(19) **Europäisches Patentamt**

**European Patent Office**

**Office européen des brevets**

(11) **EP 0 534 459 B1**

(12) **EUROPEAN PATENT SPECIFICATION**

(45) Date of publication and mention
of the grant of the patent:
**26.07.2000 Bulletin 2000/30**

(51) Int. Cl.[7]: **H01L 31/032**

(21) Application number: **92116441.4**

(22) Date of filing: **25.09.1992**

(54) **A method for producing a compound semiconductor for thin film**

Verfahren zur Herstellung einer Verbindungshalbleiter-Dünnschicht

Procédé de fabrication d'un semiconducteur composé en film mince

(84) Designated Contracting States:
**DE FR GB**

(30) Priority: **27.09.1991 JP 24902291**
**28.05.1992 JP 13657192**

(43) Date of publication of application:
**31.03.1993 Bulletin 1993/13**

(73) Proprietor:
**MATSUSHITA ELECTRIC INDUSTRIAL CO., LTD.**
**Kadoma-shi, Osaka 571-8501 (JP)**

(72) Inventors:
• **Kohiki, Shigemi**
**Osaka-shi, Osaka (JP)**
• **Negami, Takayuki**
**Katano-shi, Osaka (JP)**
• **Nishitani, Mikihiko**
**Nara-shi, Nara-ken (JP)**
• **Wada, Takahiro**
**Katano-shi, Osaka (JP)**

(74) Representative:
**Marx, Lothar, Dr.**
**Patentanwälte Schwabe, Sandmair, Marx**
**Stuntzstrasse 16**
**81677 München (DE)**

(56) References cited:
**US-A- 4 004 342**

• **ELECTRONICS LETTERS. vol. 21, no. 8, 11 April 1985, ENAGE GB pages 350 - 351 SHIH ET AL. 'CURRENT/VOLTAGE CHARACTERISTIC OF CuInSe2 HOMOJUNCTIONS'**
• **17THPHOTOVOLTAIC SPECIALISTS CONFERENCE 1 May 1984, FLORIDA, US pages 774 - 776 SHING ET AL. 'EXTRINSIC p-TYPE DOPING OF CuInSe2'**
• **JOURNAL OF MATERIALS RESEARCH vol. 7, no. 8, August 1992, pages 1984 - 1986 KOHIKI ET AL. 'X-RAY PHOTOELECTRON SPECTROSCOPY OF Cu-In-Se-N AND Cu-In-Se THIN FILMS'**
• **APPLIED PHYSICS LETTERS. vol. 59, no. 14, 30 September 1991, NEW YORK US pages 1749 - 1751 KOHIKI ETAL. 'NITROGEN IMPLANTATION FOR MOLECULAR BEAM DEPOSITED CuInSe2 THIN FILMS'**

**Description**

## BACKGROUND OF THE INVENTION

1. Field of the Invention:

The present invention relates to chalcopyrite compound semiconductors (semiconducting compounds) usable for high-efficiency thin-film solar cells, nonlinear optical elements, or the like.

2. Description of the Prior Art:

$CuInSe_2$ belongs to the $I-III-VI_2$ family of chalcopyrite semiconducting compounds. This compound is used as an absorber layer in thin-film solar cells which have very high efficiencies and long-term stable characteristics. Compound semiconductors having a chalcopyrite structure in which atoms are replaced with homologous ones, represented by:

$$(I_{1-x}-I'_x)-(III_{1-y}-III'_y)-VI_{1-z}-VI'_z)_2,$$

wherein I and I', III and III', and VI and VI' are homologous elements belonging to the same groups, respectively, are known. It is known that when some atoms of the I, III, and VI groups constituting the base of a chalcopyrite crystal structure are replaced with homologous ones, electrical, optical, and other various properties of the crystal change.

However, chalcopyrite compound semiconductors in which atoms of a VI-group element are replaced with those of an element of a different group, for example, the V or VII group, represented by $I-III-VI_{2-x}V_x$ or $I-III-VI_{2-x}VII_x$ have been reported as well.

US-A-4,004,342 teaches the use of an ion beam of a VII group element to dope a p-type chalcopyrite $I-III-VI_2$ compound with n-type impurities. The p-type chalcopyrite compound is formed by a melt growing method. The resulting single crystal is then doped by bombardment with an ion beam.

Electronic letters, vol. 21, No. 8, 11 April 1985, p. 350 to 351, discloses that the conduction type of a chalcopyrite $I-III-VI_2$ compound can be controlled by diffusion of Cu, Cd, Br, Cl and Zn for n-type or of P for p-type conduction. A single crystal chalcopyrite compound is used as starting material.

17th Photovoltaic Specialists Conference 1984, May 1-4, 1984, Florida, U.S.A., pages 774 to 776, Shing et al. "Extrinsic p-Type Doping of $CuInSe_2$" teaches to achieve n-type to p-type conversion of a single crystal chalcopyrite $I-III-VI_2$ compound by annealing at elevated temperature under an atmosphere of phosphorous vapor.

Generally, when a p-n junction is formed by two semiconductor thin films of chalcopyrite compound represented by:

$$(I_{1-x}-I'_x)-(III_{1-y}-III'_y)-(VI_{1-z}-VI'_z)_2,$$

in which some atoms are replaced homologous ones, or that of a non-stoichiometric chalcopyrite compound represented by:

$$(I_x-III_y)-VI_2,$$

wherein $x+y=2$, many defects are produced at the junction because of the difference in the lattice constant, the crystal orientation of grains with respect to the surface of the substrate, and the surface morphology at the junction. As a result, high density recombination centers are produced near the p-n junction, causing deterioration of the properties of resultant semiconductor devices such as solar cells and optical sensors.

One purpose of the present invention is to provide semiconductor devices with improved properties in which the lattice constant, the crystal orientation of grains with regard to the substrate surface, and the surface morphology are matched at the p-n junction in a $I-III-VI_2$ chalcopyrite compound semiconductor thin films by using a semiconductor thin film of chalcopyrite compounds represented by $I-III-VI_{2-x}-V_x$ or $I-III-VI_{2-x}-V_{IIx}$ (x is not 0). For simplification, hereinafter, the $I-III-VI_2$ chalcopyrite compounds also include those in which some atoms are replaced with homologous ones and those having a non-stoichiometric composition. Also, the $I-III-VI_{2-x}-V_x$ or $I-III-VI_{2-x}-VII_x$ (x is not 0) chalcopyrite compounds also include those in which some atoms are replaced with homologous ones and those having a non-stoichiometric composition.

The chalcopyrite compound semiconductor thin films represented by $I-III-VI_2$ are not good in adhesion to a substrate such as glass or a metal film on the glass. Thus arise a big problem arises when semiconductor devices are actually fabricated.

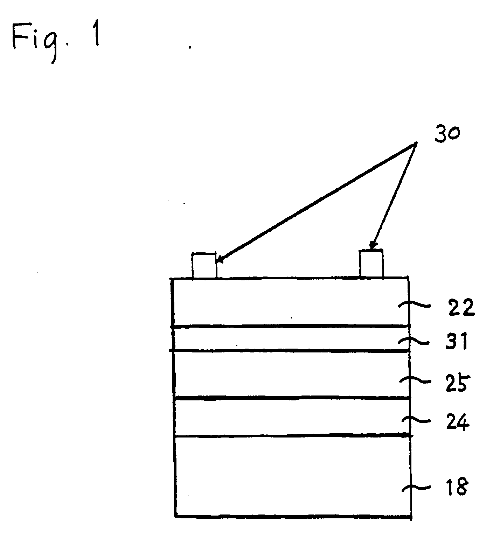

When semiconductor thin films of conventional chalcopyrite compounds such as $CuInSe_2$ are used for opto-electro transducers such as solar cells, a heterojunction of $CdS/CuInSe_2$, for example, is formed as shown in Figure 1. Figure 1 shows a structure of a conventional solar cell which comprises a glass substrate 18, and a lower electrode 24 made of Mo, a p-type $CuInSe_2$ layer 25 having a thickness of 2 $\mu m$, an n-type CdS layer 31 having a thickness of 1 $\mu m$, and a ZnO layer 22 having a thickness of 2-3 $\mu m$ formed in this order on the substrate 18. An upper metal electrode 30 is then formed on the ZnO layer 22. This structure causes failure in the lattice matching at the junction and the resultant production of high density recombination centers, which deteriorate the properties of the semiconductor devices.

To solve the aforementioned problem and to improve the properties of semiconductor devices, a yet another purpose of the present invention, which is realized by forming a homojunction in a chalcopyrite compound semiconductor thin film by doping the thin film with molecular beams or ion beams during the formation of the thin film. Moreover, solar cells, for example, the chalcopyrite compound semiconductor thin films having the homojunction according to the present invention do not contain toxic Cd. Thus, they can contribute to energy saving and environmental protection.

<u>Summary of the Invention</u>

According to the invention there is provided a method for producing a compound semiconductor thin film comprising the steps of

- forming a chalcopyrite thin film represented by $I-III-VI_2$ on a substrate in a vacuum chamber by use of molecular beams of group I, III, and VI elements or a chalcopyrite thin film represented by $I-III-VI_{2-x}VIII_x$ wherein x is not zero on a substrate in a vacuum chamber by use of molecular beams of group I, III, and VI elements and an ion beam of group VII element,
  wherein the ion beam of the group VII element scans over the substrate in said vacuum chamber while the molecular beams of group I, III, and VI elements are irradiated on the substrate, and

- forming a chalcopyrite thin film represented by $I-III-VI_{2-x}V_x$ wherein x is not zero thereon in a vacuum chamber by use of molecular beams of group I, III, and VI elements and an ion beam of group V element,
  wherein the ion beam of group V element scans over the substrate in said vacuum chamber while the molecular beams of group I, III, and VI elements are irradiated on the substrate.

Preferably the element of group I is Cu, the element of group III is In and the element of group IV is Se.

The V and VII groups include N, P, As, Sb, and Bi, and F, Cl, Br, and I, respectively. Some atoms of the V or VII group in the above compound can be further replaced with those in the same group, so as to provide a further widened variety of properties.

Thus, the invention described herein makes possible the advantages of (1) providing a chalcopyrite compound semiconductor thin film having a homojunction at which the lattice constants are matched and defects are minimized and a semiconductor device fabricated using such a film to improve the properties thereof, (2) providing a chalcopyrite compound semiconductor thin film having a good adhesion to a glass substrate and the like, and (3) providing an optoelectro transducer with improved properties comprising a chalcopyrite compound semiconductor thin film in which a homojunction is formed.

These and other advantages of the present invention will become apparent to those skilled in the art upon reading and understanding the following detailed description with reference to the accompanying figures.

## **BRIEF DESCRIPTION OF THE DRAWINGS**

Figure 1 shows the structure of a conventional $CdS/CuInSe_2$ hetero junction solar cell.

Figure 2 is a schematic sectional view of an apparatus used for producing a compound semiconductor thin film according to the present invention.

Figure 3 is an X-ray diffraction diagram of each $CuInSe_{2-x}N_x$ and $CuInSe_2$ produced according to the method of the present invention.

Figure 4 is a Raman scattering spectrum of each $CuInSe_{2-x}N_x$ and $CuInSe_2$ produced according to the method of the present invention.

Figure 5 is an X-ray photoelectron spectrum at the $Cu_{2p}$ level of each $CuInSe_{2-x}N_x$ and $CuInSe_2$ produced according to the method of the present invention.

Figure 6 is an X-ray photoelectron spectrum at the valence band of each $CuInSe_{2-x}N_x$ and $CuInSe_2$ produced according to the method of the present invention.

Figure 7 is a sectional view showing an application of the present invention to a solar cell.

Figure 8 is an X-ray diffraction diagram of $CuInSe_{2-x}P_x$ produced according to the method of the present invention.

Figure 9 is an X-ray diffraction diagram of $CuInSe_{2-x}Sb_x$ produced according to the method of the present invention.

Figure 10 is an X-ray diffraction diagram of $CuInSe_{2-x}Bi_x$ produced according to the method of the present invention.

## DESCRIPTION OF THE PREFERRED EMBODIMENTS

Example 1

In this example, a $CuInSe_2$ chalcopyrite compound semiconductor is used, and a $CuInSe_{2-x}N_x$ thin film is produced by the partial replacement of Se (a VI-group element) in the $CuInSe_2$ with N (a V-group element).

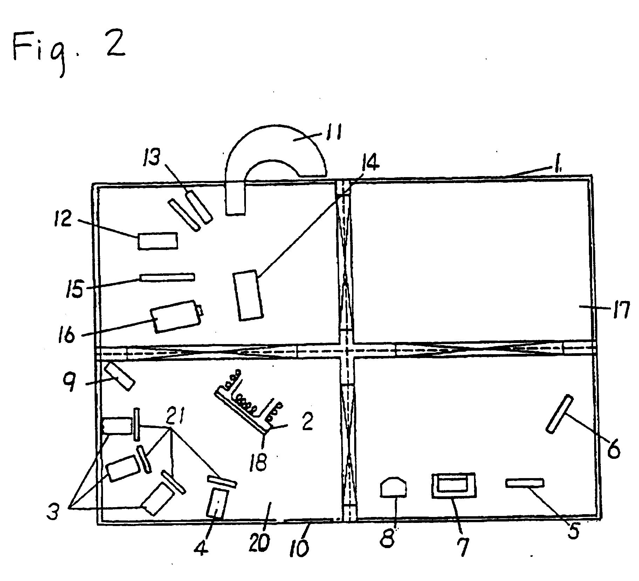

Figure 2 shows an apparatus for producing the compound semiconductor thin films and the compound semiconductor devices of this example according to the present invention. The apparatus comprises an ultra-high vacuum chamber 1 composed of four sub-chambers. One of the sub-chambers is a thin film producing chamber 20 which includes a substrate holder 2 capable of being heated and cooled, and molecular beam sources 3 and an ion source 4 for I, III, VI, and V group elements that are components of the $I-III-VI_{2-x}V_x$ compound semiconductor thin film (in this example, Cu, In, Se, and N, respectively). The vacuum chamber 1 also includes components required for film formation by sputtering and electron beam irradiation to fabricate a semiconductor device. These components include a target 5 for sputtering, an ion gun 6, a target 7 for electron beam evaporation, an electron gun 8, another electron gun 9 for thin film monitoring, a fluorescent screen 10, an electron energy analyzer 11, an X-ray source 12, an ion gun 13, a mass analyzer 14, a laser light source 15, a spectroscope 16, and an atmospherically controlled sample treatment sub-chamber 17.

The base pressure in the ultra-high vacuum chamber 1 is lowered to $10^{-10}$ millibars by using a rotary pump, an oil diffusion pump, an ion pump, a turbo pump, a Ti sublimation pump, and the like jointly. Silica glass of which surface is degreased and cleaned is used as a substrate 18. Mo is deposited on the surface of the silica glass substrate by electron beam evaporation using the target 7 for electron beam evaporation and the electron gun 8 so as to form an Mo electrode layer on the substrate 18. The substrate 18 with the Mo electrode layer formed thereon is then mounted on the substrate holder 2 in the thin film producing chamber 20. Then, a semiconductor device with $CuInSe_{2-x}N_x$/$CuInSe_2$ thin film p-n homojunction is fabricated in the following procedure.

First, an n-type $CuInSe_2$ layer of a thickness of about $5 \times 10^{-7}$ m and then a $CuInSe_{2-x}N_x$ layer of a thickness of about $10^{-6}$ m are formed on the Mo electrode layer in this order. As the molecular beam sources 3 or ion beam sources 4 for Cu, In, Se, and N, solid Knudsen cells, gas Knudsen cells, liquid source utilizing vapor pressure, or halogenated metals can be used. In this example, Cu, In, and Se metals are used for the respective molecular beam sources 3. Each metal is evaporated by heating. A cover having a small hole is placed on each source 3 so that the metal vapor is injected through the hole directly to the surface of the substrate 18 on the holder 2. A shutter 21 is formed between the substrate 18 and each source 3.

Nitrogen gas is used for the N ion beam source 4. The gas is heated and subjected to repeated electron bombardments so as to produce high-density plasma. The plasma is converged and the ions in the plasma are accelerated by a two-stage lens system, followed by mass separation through a fan-shaped magnetic field to select $N^+$ ions from the ions in the plasma, which are then converged by a multi-stage lens system and soon decelerated. The decelerated N ion beams scan over the surface of the substrate 18.

When the $CuInSe_{2-x}N_x$ layer and the $CuInSe_2$ layer are formed sequentially, switching on/off of the N ion beam source 4, adjustment of the intensity of Cu, In, and Se molecular beams, and adjustment of the temperature of the substrate holder 2 are required. The intensity of Cu, In, and Se molecular beams was adjusted by adjusting the temperature of the respective Knudsen cells in the range of 1400-1450 K, 1100-1150 K, and 400-450 K, respectively. The intensity of molecular beams were monitored by an ion monitor which provided more precise results than a film thickness meter using a quartz oscillator.

A ZnO layer is used as both a transparent electrode layer and a protective layer for the p-type $CuInSe_{2-x}N_x$

layer that is to be a light absorption layer. The ZnO transparent electrode layer is formed on the surface of the $CuInSe_{2-x}N_x$ layer by sputtering the target 5 for ZnO with Ar ions from the ion gun 6. Likewise, an ITO transparent electrode layer is formed on the ZnO layer by sputtering an target for ITO with Ar ions from the ion gun 6. Then, the resultant multi-layer structure is placed in the sample treatment sub-chamber 17 for heat treatment at a temperature of 400 K for one hour with $10^{-5}$ millibar oxygen supplied therein.

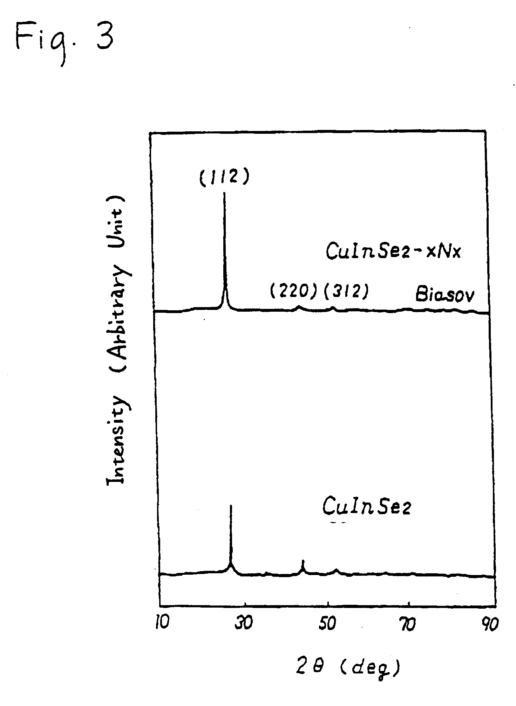

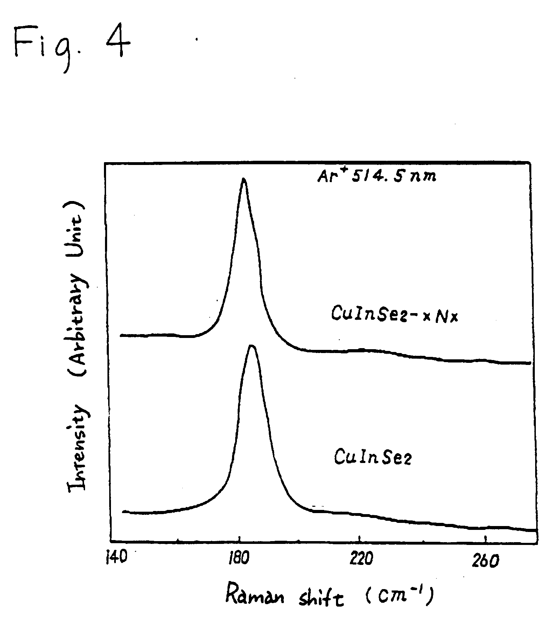

Figures 3 and 4 respectively show an X-ray diffraction diagram and a Raman scattering spectrum of each $CuInSe_{2-x}N_x$ and $CuInSe_2$. It is shown from these figures that the compound semiconductor thin film obtained by the method described above has the lattice constants matching with each other at the junction formed in the same crystal structure, and is free from segregation of intermetallic compounds and production of different types of compounds from the chalcopyrite structure.

Table 1 below shows the conductivity and the conductivity type of each Sample A ($CuInSe_{2-x}N_x$) and Sample B ($CuInSe_2$). This table shows that, while the stoichiometric $CuInSe_2$ chalcopyrite compound is an n-type having a high resistance, the $CuInSe_{2-x}N_x$ that is also stoichiometric chalcopyrite compound is a p-type with a low resistance by the partial replacement of Se with N.

Table 1

|  | Conductivity (/$\Omega$cm) | Conductivity type |
|---|---|---|
| Sample A | 2.5 | p-type |
| Sample B | $1 \times 10^{-4}$ | n-type |

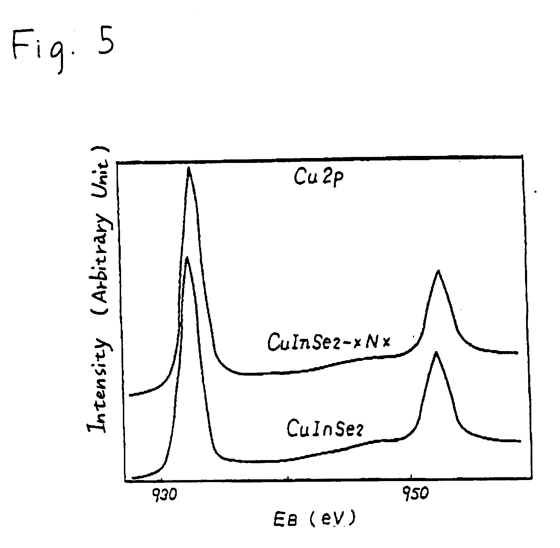

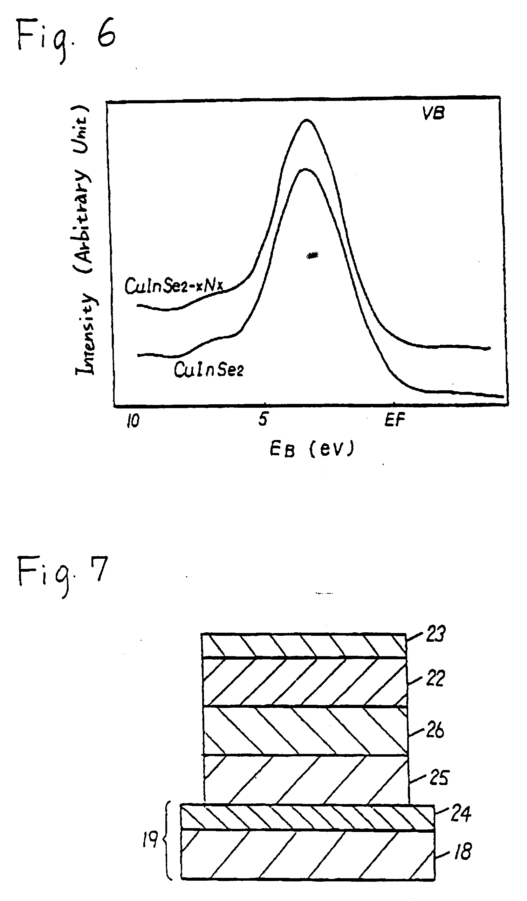

Figures 5 and 6 show X-ray photoelectron spectra of $CuInSe_{2-x}N_x$ and $CuInSe_2$ at the $Cu_{2p}$ level and the valence band, respectively. It is found from these figures that the holes formed in the valence band of $CuInSe_2$ due to the partial replacement of Se with N are localized on the Se crystal site and positioned on the $Cu_d$-$Se_p$ antibonding molecular orbital that is the highest occupied level, thereby determining the electrical properties of the compound.

Figure 7 shows one example of a solar cell using the $CuInSe_{2-x}N_x$/$CuInSe_2$ thin film produced by the aforementioned method. The solar cell has a substrate 18, an Mo layer 24, a $CuInSe_2$ layer 25, a $CuInSe_{2-x}N_x$ layer 26, a ZnO transparent layer 22, and an ITO transparent layer 23. The thin films 25 and 26 produced according to the method of the present invention have good orientation on the crystal surface, the lattice constants of the films 25 and 26 at the p-n homojunction between the films 25 and 26 can be matched with each other, and the number of defects produced at the junction can be reduced. Further, segregation of excessive components, production of different types of compounds, or other phenomena that may badly affect the electric properties of the resultant device are avoided. Therefore, highly efficient solar cells can be obtained.

Example 2

In this example, a $CuInSe_2$ chalcopyrite compound semiconductor is used, and a thin film of $CuInSe_{2-x}P_x$, $CuInSe_{2-x}Sb_x$ or $CuInse_{2-x}Bi_x$ is produced by the partial replacement of Se (a VI-group element) in the $CuInSe_2$ with P, Sb, or Bi (a V-group element).

Figure 2 shows an apparatus for producing the compound semiconductor thin films and the compound semiconductor devices of this example according to the present invention. The apparatus comprises an ultra-high vacuum chamber 1 composed of four sub-chambers. One of the sub-chambers is a thin film producing chamber 20 which includes a substrate holder 2 capable of being heated and cooled, and molecular beam sources 3 and an ion source 4 for I, III, VI, and V group elements that are components of the $I$-$III$-$VI_{2-x}V_x$ compound semiconductor thin film (in this example, Cu, In, Se, and P, Sb, or Bi, respectively). The vacuum chamber 1 also includes components required for film formation by sputtering and electron beam irradiation to fabricate a semiconductor device. These components include a target 5 for sputtering, an ion gun 6, a target 7 for electron beam evaporation, an electron gun 8, another electron gun 9 for thin film monitoring, a fluorescent screen 10, an electron energy analyzer 11, an X-ray source 12, an ion gun 13, a mass analyzer 14, a laser light source 15, a spectroscope 16, and an atmospherically controlled sample treatment sub-chamber 17.

The base pressure in the ultra-high vacuum chamber 1 is lowered to $10^{-10}$ millibars by using a rotary pump, an oil diffusion pump, an ion pump, a turbo pump, a Ti sublimation pump, and the like jointly. Silica glass of which surface is degreased and cleaned is used as a substrate 18. Mo is deposited on the surface of the silica glass substrate by electron beam evaporation using the target 7 for electron beam evaporation and the electron gun 8 so as to form an Mo electrode layer on the substrate 18. The substrate 18 with the Mo electrode layer formed thereon is then mounted on the substrate holder 2 in the thin film producing chamber 20. Then, a semiconductor device with $CuInSe_2$-

$_xP_x$/$CuInSe_2$, $CuInSe_{2-x}Sb_x$/$CuInSe_2$, or $CuInSe_{2-x}Bi_x$/$CuInSe_2$ thin film p-n homojunction is fabricated in the following procedure.

First, an n-type $CuInSe_2$ layer of a thickness of about $5 \times 10^{-7}$ m and then a $CuInSe_{2-x}P_x$, $CuInSe_{2-x}Sb_x$, or $CuInSe_{2-x}Bi_x$ layer of a thickness of about $10^{-6}$ m are formed on the Mo electrode layer in this order. As the molecular beam sources 3 or ion beam sources 4 for Cu, In, Se, and P, Sb, or Bi solid Knudsen cells, gas Knudsen cells, liquid source utilizing vapor pressure, or halogenated metals can be used. In this example, Cu, In, and Se metals are used for the respective molecular beam sources 3. Each metal is evaporated by heating. A cover having a small hole is placed on each source 3 so that the metal vapor is injected through the hole directly to the surface of the substrate 18 on the holder 2. A shutter 21 is formed between the substrate 18 and each source 3.

Yellow phosphorus is used for the P ion beam source 4. For the Sb or Bi ion beam source 4, the chloride thereof is used. Such material is heated and subjected to repeated electron bombardments so as to produce high-density plasma. The plasma is converged and the ions in the plasma are accelerated by a two-stage lens system, followed by mass separation through a fan-shaped magnetic field to select $P^+$, $Sb^+$, or $Bi^+$ ions from the ions in the plasma, which are then converged by a multi-stage lens system and soon decelerated. The decelerated P, Sb, or Bi ion beams scan over the surface of the substrate 18.

When the $CuInSe_{2-x}P_x$, $CuInSe_{2-x}Sb_x$, or $CuInSe_{2-x}Bi_x$ layer and the $CuInSe_2$ layer are formed sequentially, switching on/off of the P, Sb, or Bi ion beam source 4, adjustment of the intensity of Cu, In, and Se molecular beams, and adjustment of the temperature of the substrate holder 2 are required. The intensity of Cu, In, and Se molecular beams was adjusted by adjusting the temperature of the respective Knudsen cells in the range of 1400-1450 K, 1100-1150 K, and 400-450 K, respectively. The intensity of molecular beams were monitored by an ion monitor which provided more precise results than a film thickness meter using a quartz oscillator.

A ZnO layer is used as both a transparent electrode layer and a protective layer for the p-type $CuInSe_{2-x}P_x$, $CuInSe_{2-x}Sb_x$, or $CuInSe_{2-x}Bi_x$ layer that is to be a light absorption layer. The ZnO transparent electrode layer is formed on the surface of the $CuInSe_{2-x}P_x$, $CuInSe_{2-x}Sb_x$, or $CuInSe_{2-x}Bi_x$ layer by sputtering the target 5 for ZnO with Ar ions from the ion gun 6. Likewise, an ITO transparent electrode layer is formed on the ZnO layer by sputtering the target for ITO with Ar ions from the ion gun 6. Then, the resultant multilayer structure is placed in the sample treatment sub-chamber 17 for heat treatment at a temperature of 400 K for one hour with $10^{-5}$ millibars of oxygen supplied therein.

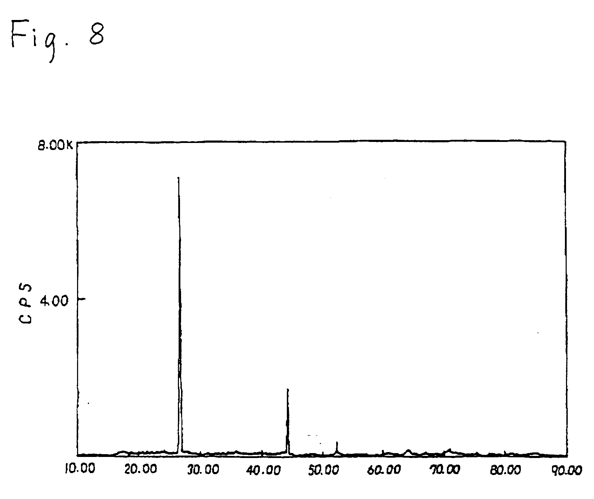

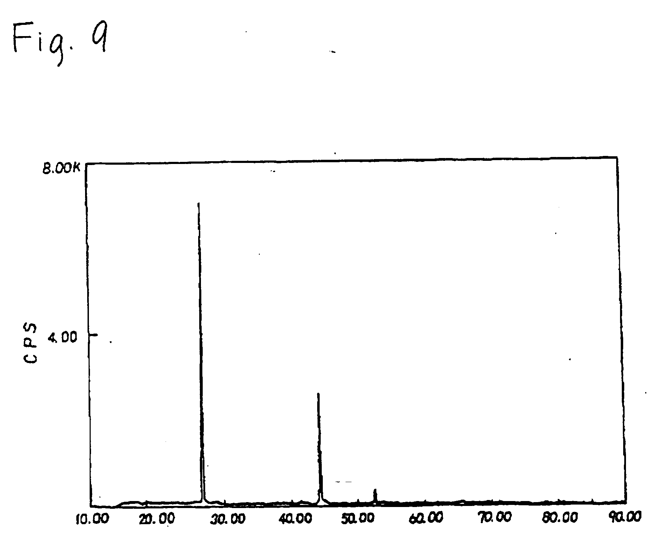

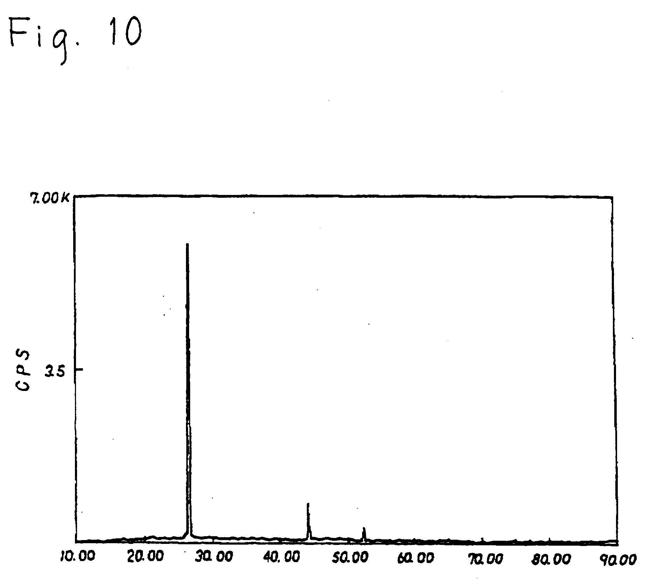

Figures 8 to 10 respectively show an X-ray diffraction diagram of $CuInSe_{2-x}P_x$, $CuInSe_{2-x}Sb_x$, and $CuInSe_{2-x}Bi_x$, respectively. It is shown from these figures that the compound semiconductor thin film obtained by the method described above has the lattice constants matching with each other at the junction formed in the same crystal structure, and is free from segregation of intermetallic compounds and production of different types of compounds from the chalcopyrite structure.

Table 2 below shows the conductivity and the conductivity type of each of Sample A ($CuInSe_{2-x}P_x$), B ($CuInSe_{2-x}Sb_x$), C ($CuInSe_{2-x}Bi_x$), and D ($CuInSe_2$). This table shows that, while the stoichiometric $CuInSe_2$ chalcopyrite compound is of n-type having a high resistance, the $CuInSe_{2-x}P_x$, $CuInSe_{2-x}Sb_x$, and $CuInSe_{2-x}Bi_x$ that are also stoichiometric chalcopyrite compounds are of p-type with a low resistance by the partial replacement of Se with P, Sb, and Bi, respectively.

Table 2

|  | Conductivity (/$\Omega$cm) | Conductivity type |
|---|---|---|
| Sample A | 0.33 | p-type |
| Sample B | 0.022 | p-type |
| Sample C | 0.025 | p-type |
| Sample D | $1.3 \times 10^{-4}$ | n-type |

Example 3

In this example, a semiconductor device having a homojunction of $I\text{-}III\text{-}VI_{2-x}V_x$ and $I\text{-}III\text{-}VI_{2-x}VII_x$ chalcopyrite compounds is described, using p-$CuInSe_{2-x}N_x$ and n-$CuInSe_{2-x}Cl_x$ as respective examples.

Figure 2 shows an apparatus for producing the compound semiconductor thin films and the compound semiconductor devices of this example according to the present invention. The apparatus comprises an ultra-high vacuum chamber 1 composed of four sub-chambers. One of the sub-chambers is a thin film producing chamber 20 which includes a substrate holder 2 capable of being heated and cooled, and molecular beam sources 3 and an ion source 4 for I, III, VI, V, and VII group elements that are components of the $I\text{-}III\text{-}VI_{2-x}V_x$ and $I\text{-}III\text{-}VI_{2-x}VII_x$ compound semiconduc-

tor thin films (in this example, Cu, In, Se, N and Cl, respectively). The vacuum chamber 1 also includes components required for film formation by sputtering and electron beam irradiation to fabricate a semiconductor device. These components include a target 5 for sputtering, an ion gun 6, a target 7 for electron beam evaporation, an electron gun 8, another electron gun 9 for thin film monitoring, a fluorescent screen 10, an electron energy analyzer 11, an X-ray source 12, an ion gun 13, a mass analyzer 14, a laser light source 15, a spectroscope 16, and an atmospherically controlled sample treatment sub-chamber 17.

The base pressure in the ultra-high vacuum chamber 1 is lowered to $10^{-10}$ millibars by using a rotary pump, an oil diffusion pump, an ion pump, a turbo pump, a Ti sublimation pump, and the like jointly. Silica glass of which surface is degreased and cleaned is used as a substrate 18. Mo is deposited on the surface of the silica glass substrate by electron beam evaporation using the target 7 for electron beam evaporation and the electron gun 8 so as to form an Mo electrode layer on the substrate 18. The substrate 18 with the Mo electrode layer formed thereon is then mounted on the substrate holder 2 in the thin film producing chamber 20. Then, a semiconductor device with $CuInSe_{2-x}N_x/CuInSe_{2-x}Cl_x$ thin film p-n homojunction is fabricated in the following procedure.

First, an n-type $CuInSe_{2-x}Cl_x$ layer of a thickness of about $5 \times 10^{-7}$ m and then a $CuInSe_{2-x}Cl_x$ layer of a thickness of about $10^{-6}$ m are formed on the Mo electrode layer in this order.

Since stoichiometric $CuInSe_2$ compounds are not good in adhesion to the Mo electrode layer, generally, a p-type $CuInSe_2$ layer having a slightly increased amount of Cu is first formed on the Mo electrode layer, and then an n-type $CuInSe_2$ layer is formed on the p-type layer, thus to obtain the n-p junction. However, this method is not so good because it has many restrictions in the manufacturing process such as the temperature at the film formation, as well as in the structure of the device. According to the present invention, a $CuInSe_2$ layer having a slightly increased amount of Cu is formed on the Mo electrode layer, as in the conventional method, so as to obtain a good adhesion to the Mo electrode layer. At the same time, however, Se in a portion of the $CuInSe_2$ layer is partially replaced with Cl, converting the portion to the n-type. Thus, the above restrictions can be markedly reduced.

As the molecular beam sources 3 or ion beam sources 4 for Cu, In, Se, N and Cl, solid Knudsen cells, gas Knudsen cells, liquid source utilizing vapor pressure, or halogenated metals can be used. In this example, Cu, In, and Se metals are used for the respective molecular beam sources 3. Each metal is evaporated by heating. A cover having a small hole is placed on each source 3 so that the metal vapor is injected through the hole directly to the surface of the substrate 18 on the holder 2. A shutter 21 is formed between the substrate 18 and each source 3.

Nitrogen gas is used for the N ion beam source 4. The gas is heated and subjected to repeated electron bombardments so as to produce high-density plasma. A metal chloride is used for the Cl ion beam source. The metal chloride is heated and subjected to repeated electron bombardments so as to produce high-density plasma. The plasma is converged and the ions in the plasma are accelerated by a two-stage lens system, followed by mass separation through a fan-shaped magnetic field to select $N^+$ and $Cl^+$ ions from the ions in the plasma, which are then converged by a multi-stage lens system and soon decelerated. The decelerated N ion beams scan over the surface of the substrate 18.

Since the $CuInSe_{2-x}N_x$ layer and the $CuInSe_{2-x}Cl_x$ layer are formed sequentially, switching on/off of the N and Cl ion beam sources 4, adjustment of the intensity of Cu, In, and Se molecular beams, and adjustment of the temperature of the substrate holder 2 are required. The intensity of Cu, In, and Se molecular beams was adjusted by adjusting the temperature of the respective Knudsen cells in the range of 1400-1450 K, 1100-1150 K, and 400-450 K, respectively. The intensity of molecular beams were monitored by an ion monitor which provided more precise results than a film thickness meter using a quartz oscillator.

As described with regard to the prior art, conventional solar cells include the $CuInSe_2/CdS$ heterojunction. Since Cd is toxic, using Cd raises an environmental problem. Also, since the lattice constants at the heterojunction do not match with each other, recombination centers are produced. As a result, the properties, e.g., the energy efficiency, of the solar cells are degraded. This example describes a novel pollution-free, high-performance solar cell structure. The solar cell excludes the use of Cd and solves the aforementioned problems by forming a homojunction of a $I-III-VI_2$ chalcopyrite compound semiconductor thin film. In this example, $CuInSe_2$ is used as a typical example of $I-III-VI_2$.

Thus, according to the present invention, novel chalcopyrite compound semiconductors represented by $I-III-VI_{2-x}V_x$ and $I-III-VI_{2-x}VII_x$ can be provided.

It is known that it is difficult to obtain stoichiometric $I-III-VI_2$ chalcopyrite compound semiconductor thin films with p-type conductivity. This relates to the fact that the electron structure of the $I-III-VI_2$ chalcopyrite compounds is basically dominated by the d-p hybridized orbital of I- and VI-group elements. If VI-group atoms that determine the highest occupied level are replaced with V-group atoms, holes are produced in the valence band. In other words, stoichiometric $I-III-VI_{2-x}V_x$ chalcopyrite compound semiconductors are of p-type conductivity. Accordingly, by the partial replacement of VI-group atoms of $I-III-VI_2$ with V-group atoms, the conductivity type is converted from n to p.

Likewise, in the $I-III-VI_{2-x}VII_x$ chalcopyrite compound semiconductors, free electrons are introduced into the lower portion of the conduction band, thus to provide the n-type conductivity. Thus, the p/n conductivity type control is possible by the partial replacement of VI-group atoms of $I-III-VI_2$ with V-group or VII-group atoms. In this way, the lattice constant is matched at the p-n junction in the same crystal structure, and the number of defects produced at the p-n junction is reduced, whereby deterioration of the properties of devices such as solar cells and optical detectors is minimized.

Further, it is possible to stoichiometrically control the metal components contained in the chalcopyrite compound semiconductor thin films and to control the conductivity type thereof by only the partial replacement of the VI-group atoms in the crystal structure. Therefore, segregating of excessive metal components and intermetallic compounds produced therefrom, production of different types of compounds from the chalcopyrite structure, or other phenomena badly affecting the electrical properties of the semiconductor devices can be avoided. In this way, the properties of various semiconductor devices using the chalcopyrite compound semiconductor thin films of the present invention can be improved. This will also lead to the possibility of novel devices having new structure such as double-hetero and triple-hetero.

Furthermore, after the fabrication of an optoelectro transducer, a homojunction can be formed in the chalcopyrite thin film by using accelerated ion beams. By using this method, conventional problems such as $I\text{-}III\text{-}VI_{2\text{-}x}V_x$, $I\text{-}III\text{-}VI_{2\text{-}x}VII_x$, failure in the lattice matching at the heterojunction and the resultant production of recombination centers can be solved. Also, according to this method, solar cells can be fabricated without using toxic Cd. Thus, the present invention can contribute to energy saving and environmental protection.

## Claims

1. A method for producing a compound semiconductor thin film comprising the steps of

   - forming a chalcopyrite thin film represented by $I\text{-}III\text{-}VI_2$ on a substrate in a vacuum chamber by use of molecular beams of group I, III, and VI elements or a chalcopyrite thin film represented by $I\text{-}III\text{-}VI_{2\text{-}x}VII_x$ wherein x is not zero, on a substrate a vacuum chamber by use of molecular beams of group I, III, and VI elements and an ion beam of group VII element,
   wherein the ion beam of the group VII element scans over the substrate in said vacuum chamber while the molecular beams of group I, III, and VI elements are irradiated on the substrate, and
   - forming a chalcopyrite thin film represented by $I\text{-}III\text{-}VI_{2\text{-}x}V_x$ wherein x is not zero thereon in a vacuum chamber by use of molecular beams of group I, III, and VI elements and an ion beam of group V element,
   wherein the ion beam of the group V element scans over the substrate in said vacuum chamber while the molecular beams of group I, III, and VI elements are irradiated on the substrate.

2. A method according to claim 1, where in the element of group I is Cu, the element of group III is In and the element of group IV is Se.

3. A method according to claim 1, wherein the element of group VII is F, Cl, Br or I.

4. A method according to claim 1, wherein the element of group V is selected from N, P, As Sb and Bi.

## Patentansprüche

1. Verfahren zur Herstellung einer Verbindungshalbeiter-Dünnschicht, umfassend die Schritte

   - Ausbilden einer Chalkopyrit-Dünnschicht, dargestellt durch $I\text{-}III\text{-}VI_2$, auf einem Substrat in einer Vakuumkammer unter Verwendung von Molekularstrahlen von Gruppe I-, III-und VI-Elementen oder einer Chalkopyrit-Dünnschicht, dargestellt durch $I\text{-}III\text{-}VI_{2\text{-}x}\text{-}VII_x$, worin x nicht null ist, auf einem Substrat in einer Vakuumkammer unter Verwendung von Molekularstrahlen von Gruppe I-, III- und VI-Elementen und einem Ionenstrahl eines Gruppe VII-Elements,
   wobei der Ionenstrahl des Gruppe VII-Elements über das Substrat in der Vakuumkammer streicht, während die Molekularstrahlen der Gruppe I-, III- und VI-Elemente das Substrat bestrahlen, und

   - Ausbilden einer Chalkopyrit-Dünnschicht dargestellt durch $I\text{-}III\text{-}VI_{2\text{-}x}V_x$, wobei x nicht null ist, darauf in einer Vakuumkammer durch Verwendung von Molekularstrahlen von Gruppe I-, III- und VI-Elementen und eines Ionenstrahls eines Gruppe V-Elements,
   wobei der Ionenstrahl des Gruppe V-Elements über das Substrat in der Vakuumkammer streicht, während die Molekularstrahlen der Gruppe I-, III- und VI-Elemente das Substrat bestrahlen.

2. Verfahren gemäß Anspruch 1, wobei das Element der Gruppe I Cu, das Element der Gruppe III In und das Element der Gruppe IV Se ist.

**3.** Verfahren gemäß Anspruch 1, wobei das Element der Gruppe VII F, Cl, Br oder I ist.

**4.** Verfahren gemäß Anspruch 1, wobei das Element der Gruppe V ausgewählt wird aus N, P, As, Sb und Bi.

**Revendications**

**1.** Procédé de fabrication d'un film mince de semiconducteur composite comprenant les étapes suivantes

- formation d'un film mince de chalcopyrite représenté par I-III-VI$_2$ sur un substrat dans une chambre à vide grâce à l'utilisation de faisceaux moléculaires d'éléments des groupes I, III et VI ou d'un film mince de chalcopyrite représenté par I-III-VI$_{2-x}$VII$_x$ où x n'est pas nul, sur un substrat dans une chambre à vide grâce à l'utilisation de faisceaux moléculaires d'éléments des groupes I, III et VI et d'un faisceau d'ions d'élément du groupe VII,
  dans lequel le faisceau d'ions d'élément du groupe VII balaie le dessus du substrat dans ladite chambre à vide tandis que les faisceaux moléculaires d'éléments des groupes I, III et VI rayonnent sur le substrat, et
- formation d'un film mince de chalcopyrite représenté par I-III-VI$_{2-x}$V$_x$ où x n'est pas nul sur celui-ci dans une chambre à vide grâce à l'utilisation de faisceaux moléculaires d'éléments des groupes I, III et VI et d'un faisceau d'ions d'élément du groupe V,
  dans lequel le faisceau d'ions d'élément du groupe V balaie le dessus du substrat dans ladite chambre à vide tandis que les faisceaux moléculaires d'éléments des groupes I, III et VI rayonnent sur le substrat.

**2.** Procédé selon la revendication 1, dans lequel l'élément du groupe I est Cu, l'élément du groupe III est In et l'élément du groupe IV est Se.

**3.** Procédé selon la revendication 1, dans lequel l'élément du groupe VII est F, Cl, Br ou I.

**4.** Procédé selon la revendication 1, dans lequel l'élément du groupe V est choisi parmi N, P, As, Sb et Bi.

Fig. 1

Fig. 2

Fig. 3

# Fig. 4

Fig. 5

Fig. 6

Fig. 7

Fig. 8

Fig. 9

Fig. 10